# EUROPEAN PATENT APPLICATION

(11) **EP 4 622 407 A1**
(43) Date of publication of application: **24.09.2025**
(21) Application number: 25163140.4
(22) Date of filing: 12.03.2025
(51) Int. Cl.: H05K 3/46, H05K 3/28, H05K 1/14, H05K 3/00

(54) **COMPONENT AND METHOD FOR MANUFACTURING A COMPONENT CARRIER**

(30) Priority: 22.03.2024 CN 202410334177
(71) Applicant: AT&S (Chongqing) Company Limited, Chongqing 401133 (CN)
(72) Inventor: CHIU, Fanyi (Michael), 235 New Taipei City (TW); ZHANG, Zachary, Hanzhong City, 723112 (CN); WANG, Elaine, Chongqing, 401120 (CN)
(74) Representative: Donatello, Daniele

(57) **Abstract**

There is described a component carrier (100), wherein the component carrier (100) comprises:
a stack (102) comprising at least one electrically conductive layer structure (104) and at least one electrically insulating layer structure (106);
a through cavity (108) extending vertically through the stack (102) delimited by sidewalls (110); and
an electrically insulating coating material (112) covering part of both opposing main surfaces (114, 116) of the stack (102) and at least part of the sidewalls (110) of the through cavity (108) of the stack (102),
wherein along at least one main planar direction (150) of the cavity (108) a change of the cavity width (155) is provided at an intermediate portion (151) of at least one sidewall (110) with respect to the, preferably straight, remaining extension of the respective sidewall (110).

There is also described a method of manufacturing a component carrier (100).

## Description

### Field of the Invention

The invention relates to a component carrier with an electrically insulation coating and a method of manufacturing a component carrier. Accordingly, the invention may relate to the technical field of component carriers, such as printed circuit boards or IC substrates, and their manufacture.

### Technical Background

In the context of growing product functionalities of component carriers equipped with one or more components and increasing miniaturization of such components as well as a rising number of components to be connected to the component carriers such as printed circuit boards, increasingly more powerful array-like components or packages having several components are being employed, which have a plurality of contacts or connections, with ever smaller spacing between these contacts. In particular, component carriers shall be mechanically robust and electrically reliable so as to be operable even under harsh conditions.

To implement or integrate components there may be provided a cavity in the component carrier in which a component is inserted. For a reliable integration of components in cavities of component carriers the dimensions of the cavities must be manufactured with high precision and with little variation of the dimensions of the cavities. However, if an electrically insulating material is applied to a component carrier with a cavity, manufacturing this cavities with little variation or tolerance in their dimensions is difficult.

### Summary of the Invention

There may be a need to provide a cavity in a component carrier in a failure robust way and with high precision.

Component carriers and a manufacturing method are described.

According to an aspect of the invention, there is described a component carrier (e.g. a printed circuit board or an IC substrate), comprising: a (multilayer) stack comprising at least one electrically conductive layer structure (e.g. a metal layer) and at least one electrically insulating layer structure (e.g. a reinforced/non-reinforced resin layer).

The component carrier comprises a through cavity (e.g. a through hole manufactured by laser processing/plasma treatment) extending vertically through the stack delimited by sidewalls.

The component carrier further comprises an electrically insulating coating material (e.g. an electrically insulating ink) covering part of both opposing main surfaces of the stack and at least part of the sidewalls of the through cavity of the stack, wherein along at least one main planar direction of the cavity a change of the cavity width is provided at an intermediate portion of at least one sidewall with respect to the, preferably straight, remaining extension of the respective sidewall.

At least one sidewall of the through cavity of the component carrier has an irregular shape. The sidewall comprises an intermediate portion at which the width of the cavity is different compared to the width of the cavity at other portions of the sidewall. Preferably, the width of the cavity at an intermediate portion of the sidewall is bigger than the width of the cavity at other portions different from the intermediate portion of the sidewall.

According to a further aspect of the invention, there is described a method of manufacturing a component carrier (e.g. as described above), the method comprising:
providing a stack comprising at least one electrically conductive layer structure and at least one electrically insulating layer structure,
forming a through cavity extending vertically through the stack delimited by sidewalls, wherein along at least one main planar direction of the cavity a change of the cavity width is provided at an intermediate portion of at least one sidewall with respect to the, preferably straight, remaining cavity extension of the respective sidewall and
applying an electrically insulating coating material on parts of both opposing main surfaces of the stack and at least part of the sidewalls of the through cavity of the stack.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. In particular, a component carrier may also be embodied as a flexible or semirigid substrate. A component carrier may also be a hybrid board combining different ones of the above mentioned types of component carriers.

In the context of the present application, the term "stack" may particularly denote an arrangement of multiple planar layer structures which are mounted in parallel on top of one another. For example, the stack may be a laminated stack, i.e. comprising a plurality of layer structures connected by the application of heat and/or pressure.

In the context of the present application, the term "layer structure" may particularly denote a continuous layer, a patterned layer or a plurality of nonconsecutive islands within a common plane.

In the context of the present application, the term "through cavity" or "cavity" may particularly denote that a cavity or opening extends through the stack so that a central axis or a symmetry axis of the cavity is perpendicular or substantially perpendicular to parallel main surfaces of the stack. The "through cavity" or "cavity" connects the two opposing main surfaces of the component carrier with each other.

In the context of the present application, the term "sidewalls" may particularly denote the lateral walls bordering the through cavity within the stack. The sidewalls may be straight or curved (for instance in a concave and/or convex fashion). Preferably, a through cavity delimited by the sidewalls of a stack may be formed by laser drilling, i.e. by processing the stack with a drilling laser beam.

In the context of the present application, the term "electrically insulating coating material" may particularly denote an electrically non-conductive filling medium filling only part of the respective through cavity while maintaining a void portion of the through cavity. The electrically insulating coating material may cover or line interior hole-defining sidewalls of the stack laterally, partly or entirely. Such a filling medium may be dielectric (for instance electrically insulating ink).

In the context of the present application, the term "main surface" of a body (such as the stack) may particularly denote one of two largest opposing surfaces of the body. The main surfaces may be connected by circumferential side walls. The thickness of a body, such as a stack, may be defined by the vertical distance between the two opposing main surfaces.

In the context of the present application, the term "main planar direction" may particularly denote a direction within the plane of one of the main surfaces of the component carrier. For example, if a through cavity is shaped like a rectangle viewed in a top view on a main surface, a main planar direction might be along the length or the width of the rectangle.

In the context of the present application, the term "cavity width" may particularly denote the distance between two opposing sidewalls of a through cavity. The cavity width is the width of the cavity without electrically insulating coating material.

In the context of the present application, the term "intermediate portion" may particularly denote a portion of a sidewall which is situated within the sidewall length and overlapping the middle of the length of the respective sidewall. The sidewall further extends in both directions of the intermediate portion of the sidewall.

According to an exemplary embodiment, a component carrier (such as a printed circuit board or an integrated circuit substrate) comprises a (preferably laminated) layer stack having one or more through cavities. The formation of the at least one through cavity may be executed (for instance by laser drilling with appropriate laser operation parameters). After the formation of the cavity an electrically insulating coating material is applied to the cavity, wherein this electrical insulating coating material covers at least a part of the sidewalls of the through cavity. Unfortunately, the thickness of the electrically insulating coating material on the sidewall(s) is not constant over the length or the width or along the sidewalls of the through cavity. The non-constant thickness of the electrically insulating coating material may have several reasons. One reason may be that the coating is affected by its surface tension when applied in a liquid or viscous state. The surface tension or strain to the electrically insulating coating material may be higher at the corners of a cavity and lead to an increased thickness here. Another reason may be the way of applying the electrically insulating coating material to the component carrier. The component carrier may be orientated perpendicular to the ground during the coating process. Thus, due to gravity, the electrically insulating coating material may flow down slowly before it is cured (by a baking process) and pile up at the intermediate portions. The non-constant thickness of the electrically insulating coating material may be even more obvious when the component carrier is turned over by 180 degree and then treated by the second coating process.

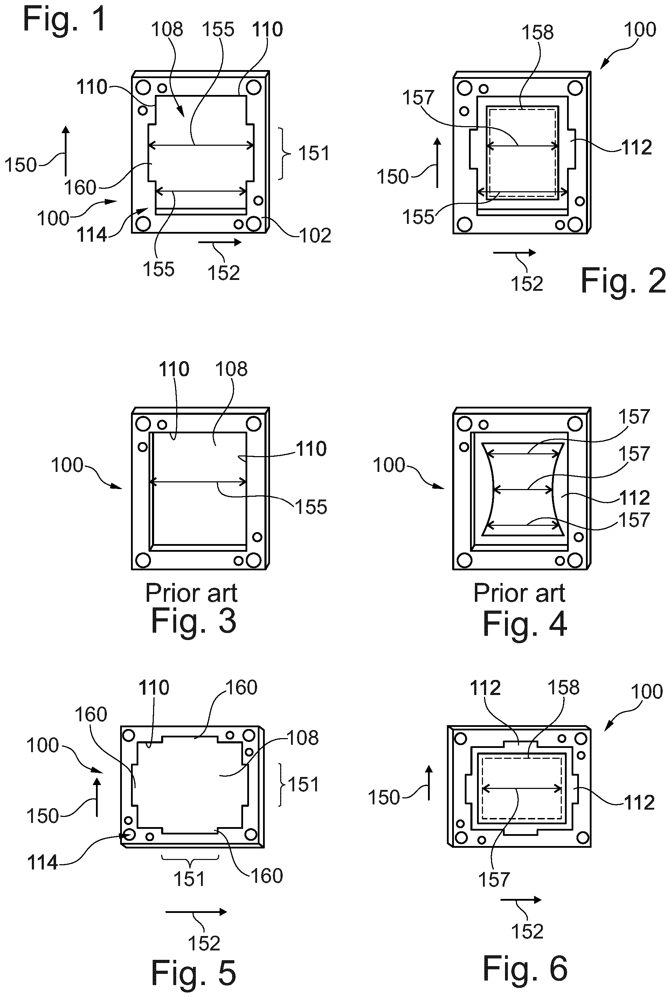

As a result, the shape of the through cavity without electrically insulating coating material differs from the shape of the remaining opening after applying the electrically insulating coating material. This shape of the remaining opening can also be denoted as final profile of the cavity. The non-constant thickness of the electrically insulating coating material along the sidewalls makes it difficult to provide precise dimensions of the final profile of the cavity of the finished component carrier. The resulting problems of the difference between the shape of the through cavity without electrically insulating coating material and the shape of the remaining opening after applying the electrically insulating coating material, which occur with component carriers according to prior art, are shown, for example, in Figures 3 and 4 and described below.

The component carrier according to the exemplary embodiment of the invention provides a change of the cavity width of the through cavity to compensate the non-constant thickness of the electrical insulating coating material on the sidewalls. It has been found out that the thickness of the electrically insulating coating material is bigger in an intermediate portion of a sidewall than at the ends of this side wall. Advantageously, a through cavity with a change of the cavity width in an intermediate portion has turned out as a proper basis for deposing or applying an electrically insulating coating material thereon, in particular in terms of precise dimensions of the final profile of the cavity. The cavity extends along at least one main planar direction. This means that the final profile of the cavity shall follow this main planar direction as precise as possible. Advantageously, a change of the cavity width provided at an intermediate portion of at least one sidewall with respect to the remaining extension of the respective sidewall effects that the change of the thickness of the electrically insulating coating material along the sidewall is compensated. In this way, the preciseness of the final profile of the through cavity with the electrically insulating coating material is significantly increased. Furthermore, by providing the change in the cavity width, the variation of the shape of the final profile during manufacturing of a plurality of component carriers of the through cavity can be significantly reduced. The change in the cavity width at an intermediate portion of the sidewall provides improved process stability for the manufacturing of component carriers with through cavities and an improved quality of the shape and dimensions of the final profile of the cavity.

Advantageously, exemplary embodiments of the invention may achieve a quite homogeneous final shape of a through cavity of a component carrier. Moreover, the dimension of the final shape of a through cavity of a component carrier can be precisely controlled by the change of cavity width so that any shape can be realized according to actual needs, for example squared, rounded, regularly stepped shape.

### Exemplary Embodiments

In an embodiment, the change of the cavity width (at the intermediate portion) comprises at least one recess arranged at at least one sidewall of the cavity of the stack, wherein at least a part of the electrically insulating coating material is partially filled in the recess. The term "recess" may refer to any cutout or section which penetrates the component carrier completely and which is situated adjacent to the cavity. The recess and the cavity are connected with each other. The recess provides space to receive/store electrically insulating coating material. Preferably a recess is situated at the intermediate portion of a sidewall and provides an increased cavity width with respect to the remaining extension of the sidewall.

In an embodiment, the recess is directed away from the center of the cavity, wherein the recess defines a part of the profile of the cavity in a plan view on at least one of the main surfaces of the stack, in particular wherein the recess has a rectangular shape in a plan view on at least one of the main surfaces of the stack. The recess is directed away from the center of the cavity. Referring to the remaining extension of the sidewall, the cavity extends into the opposite direction of the cavity. The recess is a part of the profile of the cavity. The term "profile" may refer to the shape of the circumference of the cavity in a plan view or top view without the electrically insulating coating material. The shape of the cavity in the plan view on one of the main surfaces may be a rectangular shape. The shape of the cavity may also be, at least partly, curved, rounded, triangular, trapezodial, like a parallelogram or a combination of said shapes.

In an embodiment, the recess comprises at least two portions one larger than the other, in particular defining a stepped recess. The recess may comprise two or more portions which are connected with each other. In this way, a plurality of shapes of the recess can be provided. The different portions of the recess may have different shapes. For example, a first portion of the recess may have the shape of a rectangle wherein a second portion of the recess may be shaped curved or like an arc.

In an embodiment a first portion of the recess is situated in the intermediate portion adjacent to the remaining extension of the sidewall and a second portion of the recess, which is smaller than the first portion, is situated adjacent to the side of the first portion which opposes the center of the cavity, wherein the two portions are connected with each other. In this embodiment a recess comprises two portions. A larger first portion is directly connected to the cavity and is situated adjacent to the remaining extension of the sidewall. This first portion may extend along the main planar direction along the whole length of the intermediate portion. A second, smaller portion of the recess is situated adjacent to the first portion and connected to the first portion. The second portion extends away from the center of the cavity. The first portion and a second portion may together form a stepped recess. The first portion and the second portion may have an identical shape or maybe shaped in a different way.

In an embodiment, wherein the recess comprises a length defined along the main planar direction of the cavity, wherein this length is distributed symmetrically with respect to a middle axis of the cavity in the main planar direction. To achieve a precise shape of the cavity with applied electrically insulating coating material it is advantageous to distribute the length of the recess symmetrically with respect to the middle of the length of the cavity. In the case in which the width of the recess, perpendicular to the main planar direction, in a plan view, is not constant along the length of the recess, the distribution of the width along the main planar direction may also be distributed symmetrically with respect to a middle axis of the cavity. For example, if the recess has a shape of arc or part of circle, this shape may be positioned symmetrically to the middle axis of the cavity.

In an embodiment, the cavity has at least one sidewall at least partially slanted with respect to the stack direction. In this embodiment the cavity or a recess at least partially has a slanted sidewall. The term "slanted" may refer to an orientation of at least a part of sidewall which differs from a plane perpendicular to one of the main surfaces of the component carrier. For example, a part of a sidewall may be orientated at an angle of 15° with reference to a plane perpendicular to a main surface. Such a slanted orientation of a sidewall may provide an increased surface of the sidewall which improves the adhesion of applied electrically insulating coating material.

In an embodiment the change of the cavity width comprises a gradient change of the cavity width along the main planar direction different at the intermediate portion than to the respective gradient along the remaining portions of the sidewall. In this embodiment at the intermediate portion the cavity width changes according to a gradient. The term "gradient" may refer to a progression of the cavity width which changes along the main planar direction. This change may be distributed continuously. Gradient change of the cavity width may be achieved by a recess which has the shape of an arc in a top view. The gradient at the intermediate portion differs from the gradient along the remaining extension of the remaining portions of the sidewall. In an alternative embodiment the change of the cavity width may comprise one or more steps or switches at which the cavity width changes discontinuously. A change of the width of the cavity according to a gradient may enlarge the design flexibility while at the same time ensuring an improved quality of the shape and dimensions of the final profile of the cavity. A gradient change of the cavity width allows to provide more complex forms of a final profile of a cavity. Such complex forms may be required to receive a component with a complex form within the component carrier.

In an embodiment, the cavity comprises a shape defining at least one planar development along a main planar direction, in particular along two perpendicular main planar directions, wherein a second main planar direction is perpendicular to a first main planar direction, preferably for example the length and the height of square or rectangular shaped recess or more complex shapes, for example an hexagonal shape, where the cavity width is defined by the distance of two opposed sidewalls. The cavity may extend along to two main planar directions which are orientated perpendicular to each other. For example, the shape of the cavity may be the shape of a rectangle, wherein the length of the rectangle extends along the first main planar direction and the height (or the width) of the rectangle extends along the second main planar direction. However, the cavity may also have a more complex shape which essentially extends into dimensions along the first main planar direction and the second main planar direction. For example, the shape of the cavity in a top view may be the shape of hexagonal, a polygon but also in the shape of a circle, an ellipse or a combination of different shapes. A cavity having a shape along two perpendicular main directions may create corners in which the electrically insulating coating material flows. Consequently the electrically insulating coating material may have better adhesion to the sidewalls of the cavity in near proximity to the corners.

In an embodiment, the cavity comprises rounded or slanted vertexes. The vertexes may connect sidewalls which are arranged perpendicular and adjacent to each other. The cavity may comprise vertexes comprising a continuous or steady shape. Such a shape improves adhesion of electrically insulating coating material at the vertexes and also prevent the crack at the connection portion as the stresses are dispersed. In an alternative embodiment the cavity may comprise sharp vertexes or corners. In this case an unsteady connection between two adjacent sidewalls is provided. Such sharp vertex may comprise an angle of 90° between two adjacent sidewalls.

In an embodiment, the electrically insulating coating material defines a more homogeneous lateral final profile than that the profile of the cavity without the electrically insulating coating material with a deviation of the final profile along a main planar direction of the sidewall defined by the electrically insulating coating material within a range +/- 5%, preferably 1%. The term "final profile" may refer to the shape of the cavity after applying the electrically insulating coating material. This final profile defines the dimensions of the cavity after manufacturing the component carrier. The final profile may be adapted to the outer dimensions of a component which may be integrated into the cavity. Due to the change in the cavity width at the intermediate portion before applying the electrically insulating coating material, the final profile has very small deviation from its designed and optimal shape. Along the main planar direction the tolerances of the shape of the final profile are preferably within the range of +/-1% of the optimal profile shape.

In an embodiment, the electrically insulating coating material defines a straighter lateral final profile than the profile of the cavity without the electrically insulating coating material with a resulting coated cavity width of the final profile between two opposed sidewalls coated by the insulating coating material having a deviation of at most +/- 10%, preferably of at most +/- 2%. Due to the change in the cavity width at the intermediate portion the straightness of a linear part of the final profile is significantly increased compared to prior art. The resulting coated cavity width between two opposing, linear parts of the final profile may have a very low deviation along the main planar direction of preferably at most +/- 2 %.

In an embodiment, the thickness of the electrically insulating coating material changes in circumferential direction around the cavity, wherein the thickness of the electrically insulating coating material at the intermediate portion of the sidewall is larger than at the remaining extension of the respective sidewall. The thickness of the insulating coating material around the cavity is not continuous but varies. Preferably, the largest thickness of the electrically insulating coating material at the intermediate portion(s) of the sidewall(s) where the recess(es) is/are situated and decreases indirection to the end of the remaining extension of the respective side wall. Changing thickness of the electrically insulating coating in combination with a more straight lateral final profile may create a bigger surface/interface area between the electrically insulating coating and the cavity and thus may have better adhesion compared to a constant thickness of the electrically insulating coating in combination with a more straight lateral profile.

In an embodiment the electrically insulating coating material fills at least one recess of at least one of the sidewalls completely and/or wherein the electrically insulating coating material coating the at least one sidewall compensates the width of at least one recess of a sidewall in a plan view on at least one of the main surfaces of the stack. After applying the electrically insulating coating material the change in the cavity width and/or the one or more recesses at least one of the sidewalls are no longer visible in the top view on the main surface of the component carrier. The electrically insulating coating material, which has a different thickness in different areas around the circumference of the cavity, compensates the increased cavity width of the cavity after cutting. As a result of this compensation a final profile of the cavity with very high preciseness is achieved.

In an embodiment, the distance between the final profile and the profile of the cavity without the electrically insulating coating material is larger in the intermediate portion of at least one sidewall with respect to the, preferably straight, remaining extension of the respective sidewall. The deviation between the profile of the cavity after cutting and the final profile after applying the electrically insulating coating material is largest at the intermediate portion of one or more sidewalls, where a change of the cavity width is provided. Preferably, this deviation between the two profiles decreases along the main planar direction at the ends of the remaining extensions of the respective sidewalls. By providing an adapted shape of the intermediate portion(s) with the largest cavity width in the middle of the length of a sidewall a very precise straight development of the final profile can be achieved.

In an embodiment, the shape of the electrically insulating coating material, in particular the final profile, defines rounded or slanted vertexes. The final profile may comprise steady or at least rounded vertexes. It is possible that the vertexes of the cavity profile after cutting, before applying the electrically insulating coating material, also defines rounded or slanted vertexes. Alternatively, the shape of the rounded or slanted vertexes of the final profile may be created by applying the electrically insulating coating material on a cavity profile which comprises sharp edges after cutting. Thus, applying the electrically insulating coating material may define the shape of the vertexes of the final profile.

In an embodiment, the electrically insulating coating material covers the entire sidewalls defined by the cavity. The entire surface of all sidewalls may be covered with the electrically insulating coating material. In this way, the component carrier and the cavity are very well protected against environmental influences and conductive layer structures of the stack are effectively electrically insulated against a component that may be introduced into the cavity.

In an embodiment, the electrically insulating coating material has a planar thickness along the sidewalls of the cavity changing along the final profile of the cavity profile, in particular constantly changing along the final profile. The term "planar thickness" may refer to the thickness of the electrically insulating coating material in a direction perpendicular to the surface of the sidewall of the cavity. This planar thickness changes in the circumferential direction around the final profile of the cavity. Preferably, the planar thickness along the sidewalls changes constantly. However, in areas where a recess is provided, the planar thickness of the electrically insulating coating material does not change continuously but erratic. Erratic means that the planar thickness changes abruptly at a position where the recess begins and/or ends. The changing thickness of the planar thickness of the electrically insulating coating material preferably correlates to the change in the cavity width. Thus, it is possible to provide an erratic change of the planar thickness of the electrically insulating coating material by providing an erratic development of the cavity width. In this way, the design flexibility of the final profile of the cavity can be enlarged.

In an embodiment, the thickness of the electrically insulating coating material is higher in correspondence with a larger width of the cavity, in particular within the recess. The thickness of the electrically insulating coating material is higher at positions along the main planar direction at which the cavity width is larger. Correspondingly, the thickness of the electrically insulating coating material is lower at positions where the cavity width is lower or at positions which do not belong to the intermediate portion of a sidewall but to its end portions in the main planar direction. In embodiments, which comprise one or more recesses, the thickness of the electrically insulating coating material is highest in the area of the recess(es).

In an embodiment, electrically insulating coating material delimits further sidewalls of the stack. The electrically insulating coating material may be applied also to sidewalls different from the cavity, for example lateral sidewalls of the stack. Furthermore, the electrically insulating coating material may also be, partly or totally, applied to one or both of the main surfaces of the component carrier. This may give additional mechanical and/or chemical protection to the component carrier.

In an embodiment, the recess has a length defined along a main planar direction of the cavity between 1 and 20 mm and has a width, which is perpendicular to the length, between 0,005 and 5 mm. A length of the recess may be in the range of some millimeters, wherein the corresponding width of a recess significantly lower. The absolute dimensions of the recess depend on the dimensions of the total component carrier and the cavity. Even when the component carrier having a length of larger than 10 mm, an improved quality of the shape and dimensions of the final profile of the cavity may be ensured.

In an embodiment, the recess has length which corresponds to 40% to 80% of the length of the side wall defined along a main planar direction of the cavity. Preferably, the length of the recess is adapted to the length of the respective sidewall adjacent to the recess. An adaption of the length of the recess to the length of the respective sidewall has the effect that a very precise final profile of the cavity can be achieved. The longer the sidewall is, the larger is the change of the thickness of the electrically insulating coating material along the sidewall. Thus, a larger length of the recess in a case that the (total) length of the sidewall is larger, leads to a better compensation of the changing thickness of the electrically insulating coating material.

In an embodiment, the change of the cavity width is mirrored distributed along at least one main planar planar direction, in particular along two perpendicular main planar directions. The term "mirrored distributed" may refer to a distribution of the cavity width which is symmetrical to a plane which is positioned perpendicular to one of the main planar directions and perpendicular to a main surface of the component carrier. This symmetrical distribution of the change of the cavity width provides a precise straight extension of the final profile along the main planar direction at the respective side wall.

In an embodiment, the mirrored changes of the cavity width have the same size and same position on the corresponding, in particular opposing, sidewalls. In this embodiment the mirrored changes of the cavity width are also symmetrical for two opposing sidewalls, in reference to a plane which is situated in the middle of the cavity width and perpendicular to one of the main surfaces of the component carrier. In other words, the shape of the intermediate portion of two opposing sidewalls of the cavity is identical. This configuration provides a very precise, symmetric shape of two opposing portions of the final profile.

In an embodiment, the cavity width changes along four sidewalls surrounding the cavity. If a high precision of the final profile at four or more sides of the cavity is required, a change in the cavity width between all opposing sidewalls may be provided. For example, if the final profile of the cavity shall have a shape of a precise rectangle, a change in the cavity with a long first main planar direction and a second main planar direction may be provided. In this configuration all four sidewalls of the cavity, before applying the electrically insulating coating material, have a shape that differs from a linear shape to provide the necessary change of the cavity width.

In an embodiment, the change of the cavity width has the same size and the same position on the corresponding, in particular opposing, sidewalls. The size and the position of the change in the cavity width results in a shape of the intermediate portion of a respective side wall in a top view. Preferably, this shape of the intermediate portion is the same for opposing sidewalls. Furthermore, this shape of the intermediate portion may also be identical for sidewalls that are connected with each other or are situated adjacent to each other.

In an embodiment, the component carrier is a printed circuit board or a substrate. The component carrier may also be a panel. The component carrier may be rigid or flexible.

In an embodiment, the electrically insulating coating material may comprise an ink or a resin. For example, such an electrically insulating coating material may be a solid or liquid synthetic or natural organic polymer. An example is an epoxy resin. In another example, a resin forming at least part of the electrically insulating coating may comprise polyimide and/or polytetrafluoroethylene and/or cyanate ester resin.

In an embodiment, the method comprises forming the through cavity in the stack by laser processing. In an embodiment, the cavity may be a laser cavity. The cavity may be formed in particular and preferably by laser processing. Formation of a cavity by laser processing from only one main surface of an electrically insulating layer structure may be preferred for obtaining the described shape. Advantageously, when forming the cavity by laser processing, substantially no glass fibers from prepreg material of the stack will extend into the through hole due to the impact of the laser beam. This may improve accuracy of the obtained geometry and may suppress artefacts. However, formation of a cavity may be carried out as well by other methods than laser processing, for instance by a plasma treatment, by wet etching, etc.

In an embodiment, the method comprises applying the electrically insulating coating material on the sidewalls and on parts of the main surfaces using a roller. For instance, such a roller may be a cylindrical body rotating about its central symmetry axis during operation, for instance during application of the coating. Such a roller may be moved, while rotating, longitudinally along a corresponding main surface of the stack. It has been surprisingly found that by forming the coating using a roller (rather than a scarper), enhanced balance of sidewall thickness may be achieved. This may keep the cavity center at a consistent position before and after coating. However, alternative methods of forming the coating are possible, like spray coating, screen printing, etc.

In an embodiment, the method comprises applying the electrically insulating coating material on the sidewalls and on parts of the main surfaces using a pair of rollers (which may both be embodied as described above for the roller) rolling along the opposing main surfaces of the stack, preferably rolling simultaneously along the opposing main surfaces of the stack. By taking this measure, excellent accuracy of the coating and a highly precise characteristic of the coated through hole may be achieved.

In an embodiment, a stack of the component carrier comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS2, CuGaO2, AgAlO2, LiGaTe2, AgInSe2, CuFeS2, BeO.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (and/or the curable dielectric elements) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF) and/or a combination thereof. Reinforcing structures such as webs, fibers, spheres or other kinds of filler particles, for example made of glass (multilayer glass) in order to form a composite, could be used as well. A semicured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, carbon, platinum, (doped) silicon, and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al2O3) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.
Figure 1 shows a top view of a component carrier without electrically insulating coating material, according to an exemplary embodiment of the invention.
Figure 2 shows a top view of a component carrier with electrically insulating coating material, according to an exemplary embodiment of the invention.
Figure 3 shows a top view of a component carrier without electrically insulating coating material, according to prior art.
Figure 4 shows a top view of a component carrier with electrically insulating coating material, according to prior art.
Figure 5 shows a top view of a component carrier without electrically insulating coating material, according to another exemplary embodiment of the invention.
Figure 6 shows a top view of a component carrier with electrically insulating coating material, according to another exemplary embodiment of the invention.
Figure 7 shows a top view of a component carrier without electrically insulating coating material, according to another exemplary embodiment of the invention.
Figure 8 shows a top view of a component carrier with electrically insulating coating material, according to another exemplary embodiment of the invention.
Figure 9 shows a top view of a component carrier without electrically insulating coating material, according to another exemplary embodiment of the invention.
Figure 10 shows a top view of a component carrier without electrically insulating coating material, according to another exemplary embodiment of the invention.
Figure 11 shows a perspective view of a component carrier without electrically insulating coating material, according to another exemplary embodiment of the invention.
Figure 12 shows a schematic, cut side view of a sidewall of a cavity, according to an exemplary embodiment of the invention.
Figure 13 shows a schematic, cut side view of a sidewall of a cavity, according to another exemplary embodiment of the invention.
Figure 14 shows a top view of a component carrier without electrically insulating coating material, according to another exemplary embodiment of the invention.

### Detailed Description of the Drawings

**Figure 1** shows a top view of a component carrier 100 without electrically insulating coating material 112, according to an exemplary embodiment of the invention. The top view is directed to the main surface 114 of the component carrier 100. The component carrier comprises a through cavity 108 which extends vertically at least partially, preferably entirely, through the stack 102. A first main planar direction 150 is directed along the length of the cavity 108. The cavity 108 is delimited by four side walls 110. Alternatively, the cavity may be delimited by at least five, in particular six, side walls 110. Two of these sidewalls extend along the main planar direction 150. The other two sidewalls 110 are directed perpendicular to the main planar direction 150 and perpendicular to the stack thickness direction. The two side walls 110 extending in the main planar direction 150 both comprise an intermediate portion 151. At this intermediate portion 151 a change of the cavity width 155 is provided with respect to the straight remaining extension of their respective sidewalls 110. The change of the cavity width 155 is realised by providing two recesses 160 arranged at the intermediate portions 151 of the respective sidewalls 110. Thus, the cavity width 155 at the intermediate portions 151 is larger than the cavity width 155 at the end portions of the respective sidewalls 110. The shape of the cavity 108 in the top view differs from a rectangle due to the two recesses 160. In this example, the intermediate portions 151 may be located in a central portion of the respective sidewalls 110. Additionally, the intermediate portions 151 may be located in a symmetrical manner, for example the component carrier 100 comprises at least one imaginary mirror plane. Alternatively, the intermediate portions 151 may be located in a peripheral portion of the respective sidewalls 110. In another example, the intermediate portions 151 may be located in an asymmetrical manner. Optionally at least two intermediate portions 151 may be arranged at one respective sidewall 110.

**Figure 2** shows a top view of a component carrier 100 with electrically insulating coating material 112, according to an exemplary embodiment of the invention. Figure 2 shows the same component carrier 100 as Figure 1. However, in Figure 2 and electrically insulating coating material 112 has been applied to the component carrier 100 and the cavity 108. In the illustrated embodiment the electrically insulating coating material 112 covers all sidewalls 110 of the cavity 108. Additionally, the electrically insulating coating material 112 is located on the exposed main surface of the component carrier 100. The remaining opening of the cavity 108 after applying the electrically insulating coating material 112 is indicated as final profile 158 of the cavity 108. Due to the electrically insulating coating material 112, the coated cavity width 157 is smaller than the cavity width 155 without the coating. The final profile 158 has a very precise rectangular shape. This precise rectangular shape is achieved by the change in the cavity width 155, in particular related by the introduction of the intermediate portions 151. The electrically insulating coating material 112 fully fills the two recesses 160. Thus, the thickness of the electrically insulating coating material 112 at the intermediate portions 151 of the two sidewalls 110 extending in the main planar direction 150 is larger than its thickness at the end portions of the respective sidewalls 110. The change of the cavity width 155 at the intermediate portion 151 compensates the variation of the thickness of the electrically insulating coating material 112 along the extension direction of the side walls 110. In an example, the electrically insulating coating material 112 comprises organic (polymeric) material, for example epoxy resin, poly (meth)acrylate, polyethylene terephthalate. In another example, the electrically insulating coating material may comprise inorganic material, in particular particles smaller than 300 µm, for example glass and/or ceramic. In a preferable example, the electrically insulating coating material 112 may be applied on the sidewalls and on parts of the main surfaces by using a roller. For instance, such a roller may be a cylindrical body rotating about its central symmetry axis during operation, for instance during application of the coating. Such a roller may be moved, while rotating, longitudinally along a corresponding main surface of the stack. In a further example, the electrically insulating coating material 112 may be applied by printing, in particular screen printing or 3D printing, screen coating and/or dispensing. The electrically insulating coating material 112 may have an electrically conductivity smaller than 10^-10 S/m. In an example, the electrically insulating coating material 112 may be optically reflective. In order to ensure an optically reflectivity, the electrically insulating coating material may comprise metallic particles, in particular comprising Al, Ag, Rh.

**Figure 3** shows a top view of a component carrier 100 without electrically insulating coating material, according to prior art. Figure 3 shows a component carrier 100 according to the state-of-the-art. The component carrier 100 comprises a cavity 108 with a rectangular shape. The cavity width 155 is constant along the extension of the side walls 110. There is no intermediate portion provided at which the cavity width 155 changes.

**Figure 4** shows a top view of a component carrier 100 with electrically insulating coating material 112, according to prior art. Figure 4 shows the component carrier 100 of Figure 3 after applying an electrically insulating coating material 112. The thickness of the electrically insulating coating material 112 is not constant along the (longer) extension direction of the vertical sidewalls 110. Thus, the coated cavity width 157 is also not constant along the (longer) extension direction of the vertical sidewalls 110. In prior art, the final shape of the cavity 108 differs significantly from the shape of the cavity 108 after cutting. Thus, the final shape of the cavity 108 after the coating with the electrically insulating coating material 112 is not precise at not shaped as a rectangle. It would, for example, be a problem to insert a component having a precise rectangular shape into the cavity 108 of the component carrier 100 according to the prior art shown in figure 4.

**Figure 5** shows a top view of a component carrier 100 without electrically insulating coating material 112, according to another exemplary embodiment of the invention. The embodiment shown in Figure 5 is similar to the embodiment shown in Figure 1. For elements of Figure 5 which are also shown in Figure 1, please see the description referring to figure 1. In the embodiment shown in Figure 5 there is a change in the cavity width 155 also in a second main planar direction 152. In the embodiment of Figure 5 all four sidewalls 110 comprise a recess 160 to change the cavity width 155 at an intermediate portion 151 of the respective sidewall 110. The change of the cavity width 155 is mirrored distributed along the first main planar direction 150 and the second main planar direction 152. In an example, the length and/or width of the recess 160 along the first main planar direction 150 may be the same as the length and/or width of the recess 160 along the second main planar direction 152. In another example, the length and/or width of the recess 160 along the first main planar direction 150 may be different to the length and/or width of the recess 160 along the second main planar direction 152. This may give the freedom to adjust the length and/or width of the recess in order to ensure a planar final profile 158 after applying the electrically insulating coating material 112.

**Figure 6** shows a top view of a component carrier 100 with electrically insulating coating material 112, according to another exemplary embodiment of the invention. The embodiment shown in Figure 6 is similar to the embodiment shown in Figure 2. For elements of Figure 6 which are also shown in Figure 2, please see the description referring to Figure 2. Similar to the embodiment shown in Figure 2, the cavity 108 in Figure 6 comprises final profile 158 which has a precise shape of a rectangle. Compared to the embodiments according to the prior art shown in Figures 3 and 4, the preciseness of the shape of the final profile 158 is significantly improved.

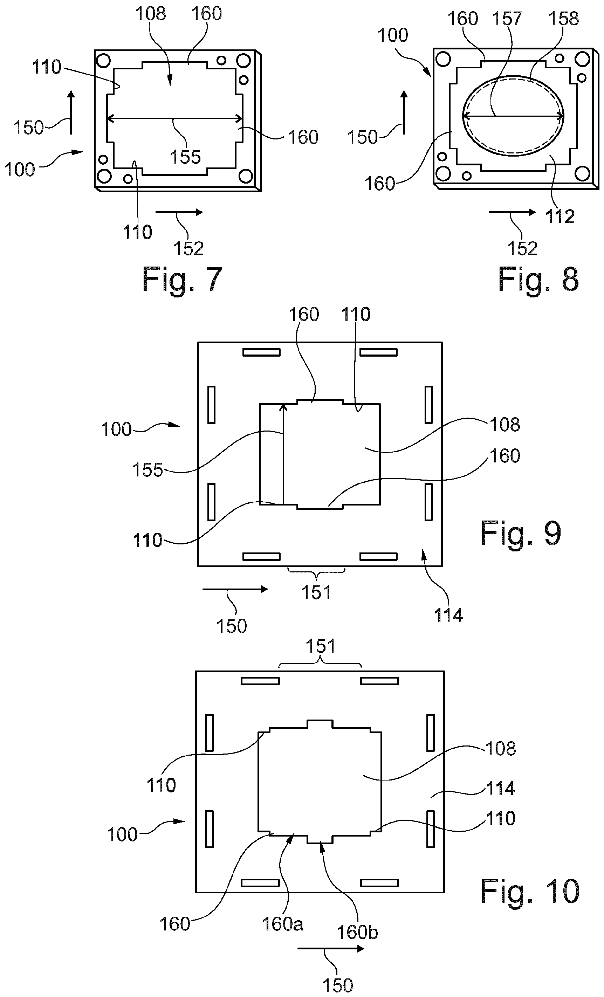

**Figure 7** shows a top view of a component carrier 100 without electrically insulating coating material 112, according to another exemplary embodiment of the invention. The embodiment shown in Figure 7 is similar to the embodiment shown in Figure 5, please see the description referring to Figure 5. Also the manufacturing steps to manufacture the component carrier 100 with a cavity 108 are identical for the embodiments shown in Figures 5 and 7. However, the embodiment shown in Figure 7 might be coated with electrically insulating coating material 112 with a higher thickness than in the embodiment shown in Figure 6. Figure 8 shows the component carrier 100 after applying electrically insulating coating material 112 with a higher thickness.

**Figure 8** shows a top view of a component carrier 100 with electrically insulating coating material 112, according to another exemplary embodiment of the invention. Figure 8 shows the component carrier 100 according to the embodiment shown in Figure 7 after applying electrically insulating coating material 112 with a higher thickness (resulting from a larger quantity of the applied electrically insulating coating material 112) to cover all surfaces of all sidewalls 110 of the cavity 108. The electrically insulating coating material 112 with a higher thickness may be applied by for example repeated roller treatment. A higher thickness of the electrically insulating coating material 112 may result from a higher total thickness of the component carrier 100. At a component carrier 100 with a higher total thickness the electrically insulating coating material 112 may pile up higher at the corner between two sidewalls due to the strain or surface tension. A higher thickness of the electrically insulating coating material 112 may also result from higher roller pitch which leads to an increased volume of applied electrically insulating coating material 112. Such an increased volume of applied electrically insulating coating material 112, and thus a higher thickness after application, may also be achieved by an increased pressure on a roller during application. Furthermore, an increased viscosity of the applied electrically insulating coating material 112 may lead to a higher thickness after the application. The electrically insulating coating material 112 fills all the recesses 160 shown in Figure 7. Furthermore, the electrically insulating coating material 112 fills all corners of the cavity 108 such as the final profile 158 has the shape of an (irregular) ellipse. Thus, the shape of the electrically insulating coating material 112, in particular the final profile 158, defines rounded or slanted vertexes. In the embodiment shown in figure 8 the coated cavity width 157 gradiently varies along the first main planar direction 150 and the second main planar direction 152. As the embodiment of Figure 8 shows, the final profile 158 of the component carrier 100 according to the invention can have different shapes. It is also possible to provide a component carrier 100 with the final profile 158 of the cavity 108 which has a shape of a precise ellipse, for example. Providing a change of the cavity width 155 of the cavity 108 before applying the electrically insulating coating material 112 may also provide a precise shape of a final profile 158 different from a rectangle. The desired shape of the final profile 158 depends, for example, on the shape of a component which is to be inserted into the component carrier 100.

**Figure 9** shows a top view of a component carrier 100 without electrically insulating coating material 112, according to another exemplary embodiment of the invention. The embodiment of a component carrier 100 shown in Figure 9 is similar to the embodiment shown in Figure 1. However, in Figure 9 the main planar direction 150 is directed from the left to the right. The cavity 108 comprises a change of the cavity width 155 along the main planar direction 150. Each of the sidewalls 110 delimiting the cavity 108 on two opposing sides comprises a recess 160 respectively. Both recesses 160 are directed away from the centre of the cavity 108. In a plan view on the main surface 114 each of the recesses 160 has a rectangular shape. The recesses may also have a quadratic or a trapezoidal shape. Each recess 160 has a length which extends along the main planar direction 150. This length of each recess 160 is distributed symmetrically with respect to a middle axis of the cavity 108, wherein this middle axis is directed vertically in Figure 9. In the embodiment shown in Figure 9 the ends of the recesses 160 in the main planar direction 150 comprise a chamfer which connects the recess 160 with the remaining extension of their respective sidewalls 110.

**Figure 10** shows a top view of a component carrier 100 without electrically insulating coating material 112, according to another exemplary embodiment of the invention. The embodiment shown in Figure 10 is similar to the embodiment shown in Figure 9. For elements of Figure 10 which are also shown in Figure 9, please see the description referring to figure 9. In the embodiment shown in Figure 10 each of the recesses 160 comprises a first portion 160a and a second portion 160b. The first portion 160a is larger than the second portion 160b. The two portions 160a, 160b together define a stepped recess 160. The first portion 160a of the recess 160 is situated in the intermediate portion 151 adjacent to the remaining extension of the respective sidewall 110 and the second portion 160b of the recess 160 is situated adjacent to the side of the first portion 160a which opposes the center of the cavity 108, wherein the two portions 160a, 160b are connected with each other. The recess 160 may also comprise more than two portions. The shape and the dimensions of the recess 160 are not limited to the embodiments shown in Figures 9 and 10. Furthermore, also the remaining sidewalls 110, delimiting the cavity 108 on the left side and on the right side, may comprise a recess 160 with one or more portions to provide a change in the cavity with 155 in a horizontal direction.

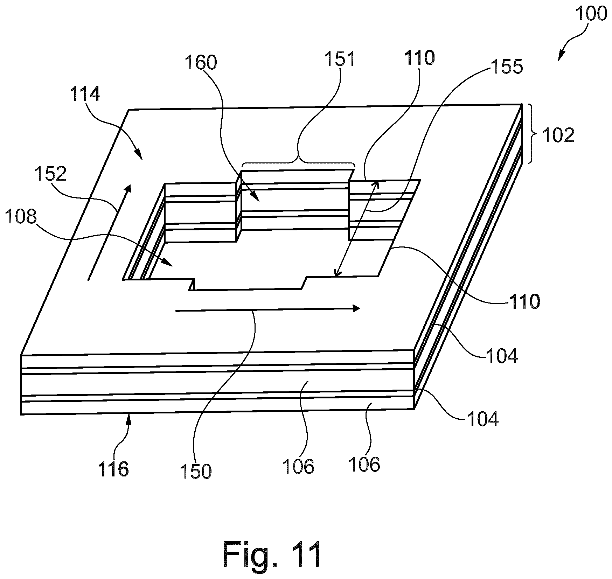

**Figure 11** shows a perspective view of a component carrier 100 without electrically insulating coating material 112, according to another exemplary embodiment of the invention. Figure 11 shows a component carrier 100 before the application of electrically insulating coating material 112. The component carrier 100 comprises a stack 102. This stack 102 comprises two conductive layer structures 104 and three electrically insulating layer structures 106 which are sandwiched with respect to each other. The surface directed upwards in Figure 11 may be defined as a first main surface 114 and the surface directed downwards may be defined as a second main surface 116. A through cavity 108 is provided which extends from the first main surface 114 to the second surface 116 and penetrates the whole stack 102. The cavity 108 may be formed in stack 102 by laser processing, said cavity 108 being delimited by sidewalls 110, which are orientated perpendicular to the main surface 114. In an example, the sidewalls 110 may be inclined to the stacking direction. The cavity 108 extends from the left to the right in a first main planar direction 150 and extends from the front to the back in second main planar direction 152. The first main planar direction 150 and the second main planar direction 152 extend perpendicular to each other. In the embodiment shown in Figure 11 a change of the cavity width 155 along the first main planar direction 150 is provided. The two opposing sidewalls 110, delimiting the cavity 108 in the front and in the back, comprise an intermediate portion 151. This intermediate portion 151 comprises a recess 160 respectively. Due to these recesses 160 the cavity width 155 in the intermediate portion 151 is larger than the cavity width 155 at the remaining extension of the respective sidewalls 110. The recesses 160 are directed away from the centre of the cavity 108. The length of the recesses 160 in the first main planar direction 150 is distributed symmetrically with respect to the middle axis of the cavity 108. This middle axis extends from the front to the back referring to Figure 11. In the embodiment shown in Figure 11 each recess 160 has a rectangular shape in a plan view on the first main surface 114. However, the shape of the recess(es) 160 is not delimited to a rectangular shape. The shape of a recess 160 in a top view on the main surface 114, 116 may also be curved, trapezoidal, triangular, like a parallelogram or according to a combination of these shapes.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

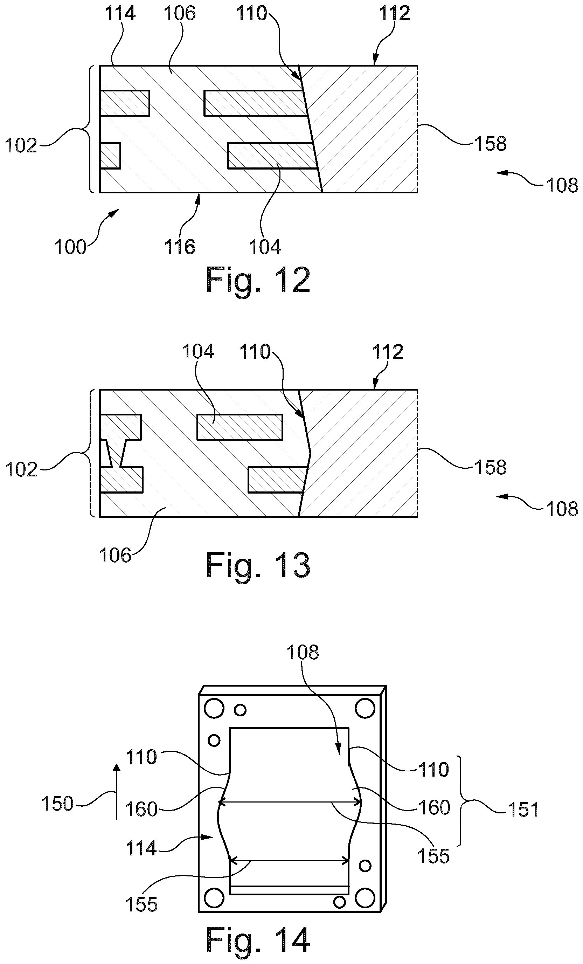

Implementation of the invention is not limited to the preferred embodiments shown in the figures and described above. Instead, a multiplicity of variants is possible which use the solutions shown and the principle according to the invention even in the case of fundamentally different embodiments. **Figure 12** shows a schematic, cut side view of a sidewall 110 of a cavity 108, according to an exemplary embodiment of the invention. Figure 12 shows only a section of a component carrier 100 with a cavity 108. The component carrier comprises a stack 102 with several electrically insulating layer structures 106 and several electrically conductive layer structures 104. The cavity 108 is situated at the right side of the illustration. In Figure 12 the cavity 108 is limited at its left side by a sidewall 110 which is coated with electrically insulating coating material 112. The sidewall 110 is slanted with respect to the stack direction. The stack direction is the vertical direction in Figure 12 and directed perpendicular to the two opposing main surfaces 114 and 116 of the component carrier 100. The slanted configuration of the sidewall 110 can be achieved by laser cutting (from main surface 114 of the component carrier). The slanted orientation of the sidewall 110 increases the surface to be applied with electrically insulating coating material 112 compared to a configuration with a sidewall 110 orientated perpendicular to the main surfaces 114, 116. However, the final profile 158 of the cavity 108 with applied electrically insulating coating material 112 is directed perpendicular to the main surfaces 114, 116. The slanted orientation of the sidewall 110 improves the adhesion of the electrically insulating coating material 112 by an increased contact surface. However, the electrically insulating coating material 112 compensates the slanted orientation of the sidewall 100 and a precise orientation of the final profile 158 perpendicular to the main surfaces 114, 116 can be achieved.

**Figure 13** shows a schematic, cut side view of a sidewall 110 of a cavity 108, according to another exemplary embodiment of the invention. The embodiment shown in Figure 13 is very similar to the embodiment shown in Figure 12. As far as not explained explicitly different, please refer to the description of Figure 12 also for Figure 13. Different to Figure 12, the embodiment in Figure 13 has a sidewall 110 which is partly slanted into two different directions with respect to the stack direction. The upper part of the sidewall 110 is slanted to the left side and the lower part is slanted to the right side. Such a configuration can be achieved by laser cutting from two opposing sides in the vertical direction. Also the sidewall 110 which is partly slanted into two different directions provides an increased contact surface to the electrically insulating coating material 112 and an improved adhesion thereof. As in the embodiment shown in Figure 12, the electrically insulating coating material 112 compensates the slanted orientation of the sidewall 100 and a precise orientation of the final profile 158 perpendicular to the main surfaces 114, 116 can be achieved.
**Figure 14** shows a top view of a component carrier 100 without electrically insulating coating material 112, according to another exemplary embodiment of the invention. The embodiment shown in Figure 14 is similar to the embodiment shown in Figure 1. As far as not explained explicitly different, please refer to the description of Figure 1 also for Figure 14. Different to Figure 1, the embodiment shown in Figure 14 comprises a gradient change of the cavity width 155 along the main planar direction 150 different at the intermediate portion 151 than to the remaining cavity extension portions of the sidewall 110. This gradient change of the cavity width 155 is provided by two recesses 160 which have the shape of an arc and which are situated at two opposing sidewalls 110, viewed in the top view of Figure 14. This gradient change of the cavity width 155 leads to a very precise final profile 158 of the cavity 108 after application of the electrically insulating coating material 112 (not shown in Figure 14). Another difference of the embodiment shown in Figure 14 to the embodiment shown in Figure 1 is that in the embodiment of Figure 14 the change of the cavity width 155 is not mirrored distributed along the main planar direction 150. In Figure 14 the change of the cavity width 155 and/or the intermediate portions 151 are not symmetrical with respect to a plane orientated perpendicular to the main surface 114 and situated in the middle of the cavity 108 in the main planar direction 150. The asymmetrical development of the cavity width 155 with a gradient in the embodiment of Figure 14 allows to enlarge the design flexibility while at the same time ensuring an improved quality of the shape and dimensions of the final profile of the cavity.

### Reference signs

100 component carrier
102 stack
104 electrically conductive layer structure
106 insulating layer structure
108 cavity
110 sidewall
112 electrically insulating coating material
114 main surface
116 main surface
150 main planar direction
151 intermediate portion
152 main planar direction
155 cavity width
157 coated cavity width
158 final profile
160 recess
160a portion
160b portion

## Claims

1. A component carrier (100), wherein the component carrier (100) comprises:
a stack (102) comprising at least one electrically conductive layer structure (104) and at least one electrically insulating layer structure (106);
a through cavity (108) extending vertically through the stack (102) delimited by sidewalls (110); and
an electrically insulating coating material (112) covering part of both opposing main surfaces (114, 116) of the stack (102) and at least part of the sidewalls (110) of the through cavity (108) of the stack (102),
wherein along at least one main planar direction of the through cavity (108) a change of the cavity width (155) is provided at an intermediate portion (151) of at least one sidewall (110) with respect to the remaining extension of the respective sidewall (110).

2. The component carrier (100) according to claim 1, wherein the change of the cavity width (155) comprises at least one recess (160) arranged at at least one sidewall (110) of the through cavity (108) of the stack (102), wherein at least a part of the electrically insulating coating material (112) is partially filled in the recess (160), in particular wherein the recess (160) is directed away from the center of the through cavity (108), wherein the recess (160) defines a part of the profile of the through cavity (108) in a plan view on at least one of the main surfaces (114, 116) of the stack (102), in particular wherein the recess (160) has a rectangular shape in a plan view on at least one of the main surfaces (114, 116) of the stack (102).

3. The component carrier (100) according to claim 2, wherein the recess (160) comprises at least two portions one larger than the other, in particular defining a stepped recess, in particular wherein a first portion (160a) of the recess (160) is situated in the intermediate portion (151) adjacent to the remaining extension of the sidewall (110) and a second portion (160b) of the recess (160), which is preferably smaller than the first portion (160a), is situated adjacent to the side of the first portion (160a) which opposes the center of the through cavity (108), wherein the first portion (160a) and the second portion (160b) are connected with each other.

4. The component carrier (100) according to claim 2 or 3, wherein the recess (160) comprises a length defined along the main planar direction of the through cavity (108), wherein this length is distributed symmetrically with respect to a middle axis of the through cavity (108) in the main planar direction.

5. The component carrier (100) according to any of claims 1 to 4, wherein the change of the cavity width (155) comprises a gradient change of the cavity width (155) along the main planar direction, the gradient of the cavity width (155)at the intermediate portion (151) different from the respective gradient along the remaining portions of the sidewall (110).

6. The component carrier (100) according to any of claims 1 to 5, wherein the electrically insulating coating material (112) defines a more regular shape, more aligned with the main planar direction(s) than the shape of the through cavity (108).

7. The component carrier (100) according to any of claims 1 to 6, wherein the electrically insulating coating material (112) coating at least one of the sidewalls (110) of the through cavity (108) defines a final profile (158) of the through cavity (108), wherein the final profile (158) is smaller than the profile of the through cavity (108) without the electrically insulating coating material (112), in particular wherein the electrically insulating coating material (112) defines a more homogeneous lateral final profile (158) than the profile of the through cavity (108) without the electrically insulating coating material (112) with a deviation of the final profile (158) along a main planar direction of the sidewall (110) defined by the electrically insulating coating material (112) within a range +/- 5%, preferably 1%.

8. The component carrier (100) according to any of claims 1 to 7, wherein the thickness of the electrically insulating coating material (112) changes in circumferential direction around the through cavity (108), wherein the thickness of the electrically insulating coating material (112) at the intermediate portion (151) of the sidewall (110) is larger than at the remaining extension of the respective sidewall (110).

9. The component carrier (100) according to any one of claims 2 to 8, wherein the electrically insulating coating material (112) fills at least one recess (160) of at least one of the sidewalls (110) completely and/or wherein the electrically insulating coating material (112) coating the at least one sidewall (110) compensates the width of at least one recess (160) of a sidewall (110) in a plan view on at least one of the main surfaces (114, 116) of the stack (102).

10. The component carrier (100) according to any of claims 1 to 9, wherein electrically insulating coating material (112) delimits further sidewalls of the stack (102).

11. The component carrier (100) according to any of claims 1 to 10, wherein the recess (160) has a length defined along a main planar direction of the through cavity (108) between 1 and 20 mm and has a width, which is perpendicular to the length, between 0,005 and 5 mm.

12. The component carrier (100) according to any of claims 1 to 11, wherein the change of the cavity width (155) is mirrored distributed along at least one main planar direction, in particular along two perpendicular main planar directions.

13. A method of manufacturing a component carrier (100), wherein the method comprises:
providing a stack (102) comprising at least one electrically conductive layer structure (104) and at least one electrically insulating layer structure (106);
forming a through cavity (108) extending vertically through the stack (102) delimited by sidewalls (110), wherein along at least one main planar direction of the through cavity (108) a change of the cavity width (155) is provided at an intermediate portion (151) of at least one sidewall (110) with respect to the remaining cavity extension of the respective sidewall (110); and
applying an electrically insulating coating material (112) on parts of both opposing main surfaces (114, 116) of the stack (102) and at least part of the sidewalls (110) of the through cavity (108) of the stack (102).

14. The method according to claim 13, wherein the method comprises forming the through cavity (108) in the stack (102) by laser processing.

15. The method according to claim 13 or 14, wherein the method comprises applying the electrically insulating coating material (112) on the sidewalls (110) and on parts of the main surfaces (114, 116) using a roller.
